# EUROPÄISCHE PATENTSCHRIFT

(11) **EP 0 612 411 B1**
(45) Veröffentlichungstag und Bekanntmachung des Hinweises auf die Patenterteilung: **30.08.1995**
(21) Anmeldenummer: 92921092.0
(22) Anmeldetag: 01.10.1992
(51) Int. Cl.: G01R 15/14, H02B 13/075

(54) **HOCHSPANNUNGSMESSEINRICHTUNG**
HIGH-VOLTAGE MEASUREMENT DEVICE
DISPOSITIF DE MESURE HAUTE TENSION

(30) Priorität: 11.11.1991 DE 4137865
(43) Veröffentlichungstag der Anmeldung: 31.08.1994
(73) Patentinhaber: SIEMENS AKTIENGESELLSCHAFT, 80333 München (DE)
(72) Erfinder: LORENZ, Dieter, D-1000 Berlin 45 (DE); GORABLENKOW, Jörg, D-1000 Berlin 20 (DE)
(86) Internationale Anmeldenummer: DE9200840
(87) Internationale Veröffentlichungsnummer: WO9310462

(56) Entgegenhaltungen:
- CH-A- 600 633
- DE-C- 3 409 016

## Beschreibung

Die Erfindung bezieht sich auf eine Hochspannungsmeßeinrichtung für eine elektrische Hochspannungsschaltanlage mit einem Kapselungsgehäuse und einer in dieses eingebauten Meßelektrode sowie einem mit dieser verbundenen, durch die Wand des Kapslungsgehäuses isoliert durchgeführten elektrischen Leiter, der ein Meßsignal führt.

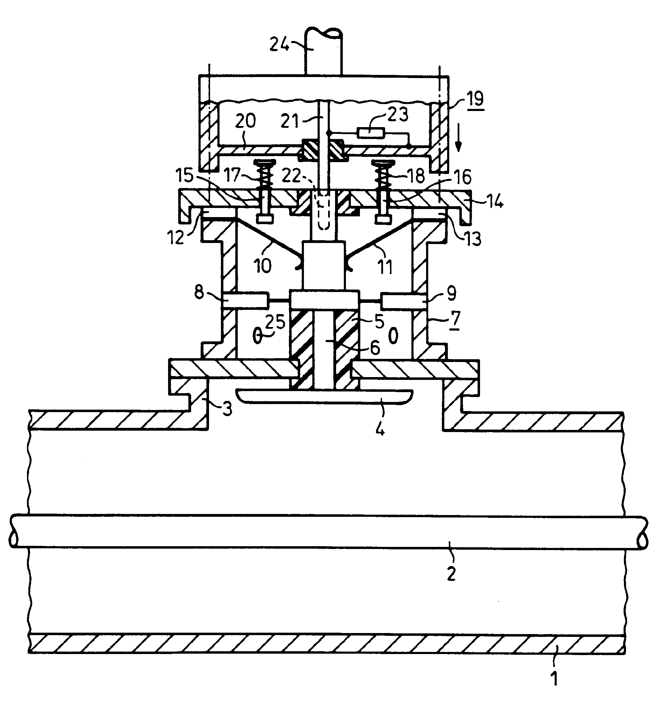

Eine derartige Meßeinrichtung ist beispielsweise aus dem Fachartikel "DESIGN AND CALIBRATION OF AN UNIVERSAL SENSOR FOR THE MEASUREMENT OF PARTIAL DISCHARGES AND VERY FAST TRANSIENTS IN GIS", SIXTH INTERNATIONAL SYMPOSIUM ON HIGH VOLTAGE ENGINEERING, New Orleans, LA, USA 28. August -1. September 1989 bekannt. Dort ist beispielsweise in der Figur 5 eine Meßsonde dargestellt, von der aus ein Leiter isoliert durch die Wand eines Kapselungsgehäuses nach außen geführt ist. Die Meßsonde wird dort zu mehreren Zwecken, nämlich für die Messung von Teilentladungen und die Messungen von schnellen Transienten mit einer jeweils passenden äußeren Beschaltung benutzt.

Aus der DE-C- 34 09 016 ist eine Hochspannungmeßeinrichtung für eine elektrische Hochspannungsschaltanlage mit einem Kapselungsgehäuse und einer in dieses eingebauten Meßelektrode sowie einem mit dieser verbundenen, durch die Wand des Kapselungsgehäuses isoliert durchgeführten elektrischen Leiter bekannt, der ein Meßsignal führt.

Die Meßelektrode ist dort durch eine Kontaktfeder gebildet, die bedarfsweise mittels eines Kontaktmessers eines Erdungsschalters mit den Phasen von Sammelschienenleitern verbunden werden kann.

Im Normalbetrieb der Schaltanlage ist die Kontaktfeder auf freiem Potential, so daß über den Leiter kapazitiv Hoch spannung aus der Schaltanlage ausgekoppelt werden kann, die dann an dem Leiter an der Außenseite des Kapselungsgehäuses anliegt und das Bedienungspersonal unter Umständen gefährdet. Lediglich im geerdeten Zustand des Erdungsschalters ist auch die Kontaktfeder und damit der durch die Wand des Kapselungsgehäuses durchgeführte Leiter geerdet und somit gefahrlos zugänglich.

Der vorliegenden Erfindung liegt die Aufgabe zugrunde, eine derartige Hochspannungsmeßeinrichtung so zu gestalten, daß sie, wenn keine Messungen vorgenommen werden, stillsetzbar ist und daß das Bedienungspersonal vor Hochspannungen an dem Leiter und an der Meßeinrichtung geschützt wird.

Die Aufgabe wird erfindungsgemäß gelöst durch einen außerhalb des Kapselungsgehäuses angeordneten, geerdeten, in dem Fall, daß kein Meßgerät an den Leiter angeschlossen ist, zur Erdung des Leiters auf diesem aufliegenden, bedarfsweise bei Anschluß eines Meßgerätes von diesem abhebbaren federnden Kontakt.

Durch diesen federnden Kontakt ist der Leiter im Normalzustand, wenn der Kontakt nicht abgehoben ist, geerdet, so daß außerhalb des Kapselungsgehäuses der Schaltanlage keine Hochspannungen an dem Leiter auftreten können. Auch die an den Leiter angeschlossene Einrichtung zur Verarbeitung von Meßsignalen wird gegebenenfalls, sofern keine Messung vorgesehen ist, vom Einfluß der Hochspannung ferngehalten.

Die Erfindung wird vorteilhaft durch ein bedarfsweise auf den Leiter aufsetzbares, eine Vorrichtung zur Verarbeitung und/oder Weiterleitung des Meßsignals umschließendes Schaltungsgehäuse ausgestaltet, welches mit einer Einrichtung verbunden ist, die mit dem Aufsetzen auf den Leiter den Kontakt von diesem abhebt.

Durch die Einrichtung zum Abheben des Kontaktes wird jeweils vor Beginn einer Messung, wenn das Schaltungsgehäuse auf den Leiter aufgesetzt wird, der Kontakt von dem Leiter abgehoben, so daß die Erdverbindung unterbrochen ist. Der Leiter kann dann elektrische Signale aus dem Inneren des Kapselungsgehäuses nach außen führen. Nach Beendigung des Messung kann das Schaltungsgehäuse vom Leiter abgenommen werden, wobei sich der Kontakt selbsttätig wieder gegen den Leiter legt und diesen erdet. Dadurch ist bei abgenommenem Schaltungsgehäuse keine Gefährdung des Bedienungspersonals durch an dem Leiter auftretende Hochspannung zu befürchten.

Eine weitere vorteilhafte Ausgestaltung der Erfindung sieht vor, daß das Schaltungsgehäuse auf ein den Kontakt enthaltendes Meßgehäuse mit wenigstens einem von außen betätigbaren Abhebelement für den Kontakt derart aufsetzbar ist, daß das Abhebeelement dauerhaft betätigt wird.

Das Meßgehäuse umschließt einen Teil des Leiters und den Kontakt, so daß dieser vor Beschädigungen geschützt ist. Außerdem ist an dem Meßgehäuse ein Abhebeelement für den Kontakt vorgesehen, das beispielsweise aus einem in das Innere des Meßgehäuses ragenden Hebel oder Stift besteht, der von außen gegen die Kraft einer Rückstellfeder betätigbar ist und durch seine Betätigung den Kontakt von dem Leiter abhebt. Der Stift oder Hebel besteht aus leitendem Material, so daß, in dem Moment, in dem der Kontakt abgehoben wird, das Schaltungsgehäuse mit der Schaltung auf Erdpotential liegt.

Bei dieser Konstruktion ist der Leiter in der abgehobenen sowie in der nichtabgehobenen Position, also in nichtgeerdetem und geerdetem Zustand zum Schutze des Bedienungspersonals von einem Gehäuse umschlossen. Auch bei der Betätigung bei der Abhebeelemente tritt keine Gefährdung ein.

Wenn durch einen in der Schaltanlage auftretenden Fehler ein hoher Strom auf die Meßsonde gelangt, der über den Kontakt zur Erde abgeleitet wird, kann der Kontakt explosionsartig verdampfen und die Erdverbindung des Leiters abrupt unterbrechen. Die dabei entstehenden heißen Gase werden durch das Meßgehäuse zurückgehalten, so daß auch hierdurch keine Gefährdung des Bedienungspersonals gegeben ist.

Eine besonders vorteilhafte Ausgestaltung der Erfindung sieht vor, daß die Vorrichtung zur Verarbeitung und/oder Weiterleitung des Meßsignals mit einem Ende des Leiters über einen durch das Aufsetzen des Schaltungsgehäuses auf den Leiter zusammenfügbaren Steckkontakt verbindbar ist.

Durch diese Konstruktion ergibt sich, daß das Schaltungsgehäuse mit der Vorrichtung zur Verarbeitung und/oder Weiterleitung des Meßsignals lediglich auf den Leiter aufgesetzt werden muß, um einen leitenden Kontakt herzustellen. Gegebenenfalls kann gleichzeitig durch das Aufsetzen des Schaltungsgehäuses der Kontakt von dem Leiter abgehoben werden. Dies gestattet eine sehr einfache und sichere Bedienung der Meßeinrichtung. Die Meßeinrichtung kann dabei, sofern sie nicht benötigt wird, abgenommen werden oder sie kann im Falle unterschiedlicher Meßvorhaben durch ein eine andere Schaltungsanordnung enthaltendes Schaltungsgehäuse ersetzt werden, beispielsweise wenn abwechselnd Teilentladungsmessungen und Messungen schneller Transienten vorgenommen werden sollen.

Zusätzlich kann vorteilhaft der Leiter über einen Überspannungsableiter mit dem Erdpotential verbunden sein, um Hochspannungen, deren Potential wesentlich höher liegt als das der zu messenden Spannungen, gegen Erde abzuleiten.

Auch bei abgehobenem Kontakt wird die Spannung durch den Überspannungsableiter begrenzt. Ein übergroßer Stromimpuls, der in diesem Zustand einläuft, zerstört den Überspannungsableiter, richtet aber insbesondere an der Schaltungsanordnung keinen Schaden an.

Das Meßgehäuse verfügt vorteilhafterweise über wenigstens eine Ausblasöffnung, um im Falle des Verdampfens des Kontaktes durch einen hohen Stromimpuls die entstehenden Gase abführen zu können. Die Ausblasöffnung weist vorteilhaft eine Umlenkvorrichtung für das ausgeblasene Gas auf, um dieses in eine Richtung zu lenken, in der keine Gefährdung des Bedienungspersonals auftritt.

Der Leiter und das Meßgehäuse sind so gestaltet, daß verschiedene, unterschiedliche Schaltungsanordnungen enthaltende Schaltungehäuse alternativ auf den Leiter aufsetzbar sind.

Im folgenden wird die Erfindung anhand eines Ausführungsbeispiels in einer Zeichnung gezeigt und anschließend beschrieben.

Dabei zeigt die Figur schematisch in einem Längsschnitt ein Kapselungsgehäuse mit einer Meßsonde, einem Meßgehäuse und einem Schaltungsgehäuse.

Die Figur zeigt
ein Kapselungsgehäuse 1 mit einem zentrischen Hochspannungsleiter 2. In einem Anschlußstutzen 3 des Kapselungsgehäuses 1 befindet sich eine Meßelektrode 4, die sich derart in die Wand des Kapselungsgehäuses 1 einfügt, daß sich im Ganzen eine dielektrisch günstige Kontur ergibt. Die Meßelektrode 4 ist mit einem Leiter 6 verbunden, der isoliert durch die Wand des Kapselungsgehäuses hindurchgeführt ist. Dazu ist ein Isolator 5 vorgesehen, der mit dem Leiter 6 einerseits und der Wand des Kapselungsgehäuses 1 andererseits gasdicht abschließt. Außerhalb des Kapselungsgehäuses 1 ist auf dieses ein Meßgehäuse 7 aufgesetzt, welches das aus dem Kapselungsgehäuse 1 hinausragende Ende des Leiters 6 umschließt. Das Meßgehäuse 7 ist leitend mit dem Kapselungsgehäuse 1 verbunden und befindet sich auf Erdpotential. Der Leiter 6 ist über zwei Überspannungsableiter 8, 9 mit dem Meßgehäuse 7 verbunden.

An dem Meßgehäuse sind leitend zwei federnde Kontakte in Form von Metallfedern 10, 11 befestigt, die auf dem Leiter 6 federnd aufliegen und diesen leitend mit dem Meßgehäuse 7 verbinden. Es sind in dem Meßgehäuse Ausblasöffnungen 12, 13 vorgesehen, durch die bedarfsweise heißes Gas entweichen kann, welches beispielsweise durch Verdampfen der Metallfedern bei einem überhöhten Stromimpuls entsteht.

In dem Deckel 14 des Meßgehäuses 7 sind zwei Betätigungselemente in Form von metallischen Stiften 15, 16 in Richtung der Längsachse des Leiters 6 verschiebbar angeordnet. Diese sind gegen die Kraft je einer Rückstellfeder 17, 18 in Richtung der Metallfedern 10, 11 soweit verschiebbar, bis daß die Metallfedern 10, 11 von dem Leiter 6 abheben und damit den Erdkontakt unterbrechen.

Die Stifte werden durch Aufsetzen des Schaltungsgehäuses 19 auf das Meßgehäuse 2 betätigt. Der Boden 20 des Schaltungsgehäuses drückt dabei gegen die Enden der Stifte 15, 16. An seinem Boden 20 weist das Schaltungsgehäuse 19 einen Kontaktstift 21 auf, der den Boden 20 durchdringt und beim Aufsetzen auf das Meßgehäuse 2 in einen Gegenkontakt 22 einfährt, der durch ein Ende des Leiters 6 gebildet ist. Dadurch wird der Kontakt zwischen der in dem Schaltungsgehäuse 19 angeordneten Schaltungsanordnung und dem Leiter 6 hergestellt. Diese Steckverbindung ist so dimensioniert, daß der Kontaktstift 21 in den Gegenkontakt 22 einfährt, bevor die Metallfedern 11, 12 abgehoben werden.

Von der in dem Schaltungsgehäuse 19 angeordneten Schaltungsanordnung ist der Einfachheit halber lediglich ein Widerstand 23 dargestellt, der die äußere Beschaltung für den Fall der Teilentladung darstellt.

Sollen schnelle transiente Überspannungen gemessen werden, so wird der Widerstand 23 zweckmäßig durch einen Kondensator ersetzt, der die Streukapazität der Meßsonde 4 zum Erdpotential und damit die Kapazität des durch die Meßsonde 4 und das Kapselungsgehäuse 1 gebildeten Unterspannungskondensators vergrößert.

Von dem Schaltungsgehäuse 19 aus führt eine Meßleitung 24 zu weiteren, nicht dargestellten Meßgeräten, in denen die Meßsignale weiterverarbeitet werden.

Das Meßgehäuse 7 weist zusätzlich zu den Ausblasöffnungen 12, 13 Belüftungsbohrungen 25 auf, um gute Luftzirkulation zur Begrenzung der Luftfeuchtigkeit im Falle eines Freilufteinsatzes zu gewährleisten.

## Patentansprüche

1. Hochspannungsmeßeinrichtung für eine elektrische Hochspannungsschaltanlage mit einem Kapselungsgehäuse (1) und einer in dieses eingebauten Meßelektrode (4) sowie einem mit dieser verbundenen, durch die Wand des Kapselungsgehäuses (1) isoliert durchgeführten elektrischen Leiter (6), der ein Meßsignal führt,
**gekennzeichnet durch** einen außerhalb des Kapselungsgehäuses (1) angeordneten, geerdeten, in dem Fall, daß kein Meßgerät an den Leiter (6) angeschlossen ist, zur Erdung des Leiters (6) auf diesem aufliegenden, bedarfsweise bei Anschluß eines Meßgerätes von diesem abhebbaren federnden Kontakt (10, 11).

2. Hochspannungsmeßeinrichtung nach Anspruch 1,
**gekennzeichnet durch** ein bedarfsweise auf den Leiter (6) aufsetzbares, eine Vorrichtung zur Verarbeitung und/oder Weiterleitung des Meßsignals umschließendes Schaltungsgehäuse (19), welches mit einer Einrichtung verbunden ist, die mit dem Aufsetzen auf den Leiter (6) den Kontakt (10, 11) von diesem abhebt.

3. Hochspannungsmeßeinrichtung nach Anspruch 2,
**dadurch gekennzeichnet**, daß das Schaltungsgehäuse (19) auf ein den Kontakt (10, 11) enthaltendes Meßgehäuse (7) mit wenigstens einem von außen betätigbaren Abhebeelement (15, 16) für den Kontakt (10, 11) derart aufsetzbar ist, daß das Abhebeelement (15, 16) dauerhaft betätigt wird.

4. Hochspannungsmeßeinrichtung nach Anspruch 1 oder einem der folgenden,
**dadurch gekennzeichnet**, daß die Vorrichtung zur Verarbeitung und/oder Weiterleitung des Meßsignals mit einem Ende des Leiters (6) über einen durch das Aufsetzen des Schaltungsgehäuses (19) auf den Leiter (6) zusammenfügbaren Steckkontakt (21, 22) verbindbar ist.

5. Hochspannungsmeßeinrichtung nach Anspruch 1 oder einem der folgenden,
**dadurch gekennzeichnet**, daß der Leiter (6) über einen Überspannungsableiter (8, 9) mit dem Erdpotential verbunden ist.

6. Hochspannungsemßeinrichtung nach Anspruch 3 oder einem der folgenden,
**dadurch gekennzeichnet**, daß das Meßgehäuse (7) über wenigstens eine Ausblasöffnung (12, 13) verfügt.

7. Hochspannungsmeßeinrichtung nach Anspruch 6,
**dadurch gekennzeichnet**, daß die Ausblasöffnung (12, 13) eine Umlenkvorrichtung für das ausgeblasene Gas aufweist.

8. Hochspannungsmeßeinrichtung nach Anspruch 1 oder einem der folgenden,
**dadurch gekennzeichnet**, daß verschiedene, unterschiedliche Schaltungsanordnungen enthaltende Schaltungsgehäuse (19) alternativ auf den Leiter (6) aufsetzbar sind.

## Claims

1. High voltage measuring device for electric high-voltage switchgear, having an encapsulating housing and a measuring electrode (4) incorporated therein, as well as an electrical conductor (6) connected to said electrode and passing in an insulated manner through the wall of the encapsulating housing (1), which conductor carries a measuring signal,
characterised by an earthed resilient contact (10, 11) which is disposed outside the encapsulating housing (1) and which, if no measuring device is connected to the conductor (6), rests on said conductor in order to earth same, but which can be lifted off if necessary when a measuring device is connected.

2. High voltage measuring device according to claim 1,
characterised by a circuit housing (19) enclosing a device, which may if necessary be placed on the conductor (6), for processing and/or passing on the measuring signal, the circuit housing being connected to a device which, when placed on the conductor (6) lifts the contact (10, 11) therefrom.

3. High voltage measuring device according to claim 2,
characterised in that the circuit housing (19) can be placed on a measuring housing (7) containing the contact (10, 11) and having at least one element (15, 16) for lifting the contact (10, 11), which element is actuatable from outside in such a manner that the lifting element (15, 16) is permanently actuated.

4. High voltage measuring device according to claim 1 or one of the subsequent claims,
characterised in that the device for processing and/or passing on the measuring signal is connectable to one end of the conductor (6) via a plug contact (21, 22) which can be joined by placing the circuit housing (19) on the conductor (6).

5. High voltage measuring device according to claim 1 or one of the subsequent claims,
characterised in that the conductor (6) is connected to earth potential via a discharger (8, 9).

6. High voltage measuring device according to claim 3 or one of the subsequent claims,
characterised in that the measuring housing (7) has at least one blow-out aperture (12, 13).

7. High voltage measuring device according to claim 6,
characterised in that the blow-out aperture (12, 13) has a device for diverting the blow-out gas.

8. High voltage measuring device according to claim 1 or one of the subsequent claims,
characterised in that circuit housings (19) containing various different circuit arrangements can be placed on the conductor (6) as an alternative.

## Revendications

1. Dispositif de mesure en haute tension pour une installation électrique de coupure en haute tension comportant un boîtier d'encapsulation (1) et une électrode de mesure (4) montée dans ce boîtier, ainsi qu'un conducteur électrique (6) relié à cette électrode et qui traverse avec isolation la paroi du boîtier d'encapsulation (1) et délivre un signal de mesure,
caractérisé par un contact élastique (10,11) raccordé à la terre, qui est disposé à l'extérieur du boîtier d'encapsulation (1), et s'applique sur le conducteur (6), pour la mise à la terre de ce dernier, dans le cas où aucun appareil de mesure n'est raccordé au conducteur (6), et peut être écarté en cas de besoin de l'appareil de mesure lors du raccordement de l'appareil de mesure.

2. Dispositif de mesure en haute tension suivant la revendication 1, caractérisé par un boîtier de commande (19) qui peut, le cas échéant, être monté sur le conducteur (6) et commute un dispositif pour le traitement et/ou la transmission du signal de mesure et qui est relié à un dispositif qui, lors du montage sur le conducteur (6), écarte de celui-ci le contact (10,11).

3. Dispositif de mesure en haute tension suivant la revendication 2, caractérisé par le fait que le boîtier de commande (19) peut être monté sur un boîtier de mesure (7), qui contient le contact (10,11) et qui comporte au moins un élément d'écartement (15,16), pouvant être actionné de l'extérieur, pour le contact (10,11) de telle sorte que l'élément d'écartement (15,16) est actionné de façon permanente.

4. Dispositif de mesure en haute tension suivant la revendication 1 ou l'une des suivantes, caractérisé par le fait que le dispositif de traitement et/ou de retransmission du signal de mesure peut être relié à une extrémité du conducteur (6) par l'intermédiaire d'un contact à enfichage (21,22), qui peut être réuni, sous l'effet de l'application du boîtier de circuit (19), sur le conducteur (6).

5. Dispositif de mesure en haute tension suivant la revendication 1 ou l'une des suivantes, caractérisé par le fait que le conducteur (6) est relié au potentiel de terre par l'intermédiaire d'un dispositif de dérivation des surtensions (8,9).

6. Dispositif de mesure en haute tension suivant la revendication 3 ou l'une des suivantes, caractérisé par le fait que le boîtier de mesure (7) comporte au moins une ouverture d'évacuation par soufflage (12,13).

7. Dispositif de mesure en haute tension suivant la revendication 6, caractérisé par le fait que l'ouverture d'évacuation par soufflage (12,13) possède un dispositif de déviation pour le gaz évacué par soufflage.

8. Dispositif de mesure en haute tension suivant la revendication 1 ou l'une des suivantes, caractérisé par le fait que différents boîtiers de commandes (19) contenant différents montages, peuvent être appliqués alternativement sur le conducteur (6).
